# EUROPÄISCHE PATENTANMELDUNG

(11) **EP 3 404 429 A1**
(43) Veröffentlichungstag der Anmeldung: **21.11.2018**
(21) Anmeldenummer: 18169248.4
(22) Anmeldetag: 25.04.2018
(51) Int. Cl.: G01R 31/02, G01R 31/00

(54) **KONDENSATOR MIT INTEGRIERTER MESSEINRICHTUNG**

(30) Priorität: 19.05.2017 DE 102017110990
(71) Anmelder: Fischer, Bennet, 13353 Berlin (DE)
(72) Erfinder: Fischer, Bennet, 13353 Berlin (DE)
(74) Vertreter: Lobemeier, Martin Landolf

(57) **Zusammenfassung**

Kondensator (10) mit zwei Kondensatoranschlüssen (20, 30), und einer wenigstens einen Betriebsparameter des Kondensators (10) als Messdaten erfassenden, wenigstens einen Sensor (40) aufweisenden Messeinrichtung (50), die zur eigenen Spannungsversorgung an die Kondensatoranschlüsse (20, 30) des Kondensators (10) angeschlossen ist, dadurch gekennzeichnet, dass die Messeinrichtung (50) einen die Messdaten und/oder daraus abgeleitete Daten speichernden Datenspeicher aufweist, und der Datenspeicher zum Speichern einer Häufigkeit oder einer Dauer eines in einem ersten Wertebereich eines ersten Betriebsparameters erfolgenden Ereignisses in Abhängigkeit von einem zweiten Wertebereich eines zweiten Betriebsparameters eingerichtet ist.

## Beschreibung

Die Erfindung betrifft einen Kondensator mit zwei Kondensatoranschlüssen und einer wenigstens einen Betriebsparameter des Kondensators als Messdaten erfassenden, wenigstens einen Sensor aufweisenden Messeinrichtung, die zur eigenen Spannungsversorgung an die Kondensatoranschlüsse des Kondensators angeschlossen ist.

Derartige Kondensatoren sind beispielsweise aus der EP 2 418 663 A2, der CN 205 246 788 U und der CN 204 118 856 U bekannt.

Im Regelfall sind Kondensatoren bei applikationsgemäßer Dimensionierung als langzeitbeständige Bauelemente anzusehen. Dennoch sind sie insbesondere bei abweichenden bis extremen Beanspruchungssituationen schadensgefährdet. Speziell betrifft das situationsbezogene überdimensionale Stromstöße bzw. thermische Überbeanspruchungen, die trotz entsprechender Sicherungsmaßnahmen nicht völlig ausgeschlossen werden können.

Vor allem thermische Belastungen können trotz sorgfältiger Dimensionierung nicht ausgeschlossen werden, wobei vor allem kumulierend sich aufbauende Temperaturfelder problematisch sind. Durch die Energiecharakteristik der Kondensatoren sind diese bei thermischer Überbeanspruchung nicht nur in ihrer Eigenfunktion gefährdet (bis hin zum vollständigen Ausfall), vielmehr kann das Temperaturfeld der elektrischen/elektronischen Baugruppe derart verändert werden, dass thermisch sensible Bauelemente geschädigt werden können.

Als Konsequenz können bei Ausfall von Kondensatoren oder infolge von durch Kondensatoren verursachten lokalen Überhitzungen also komplette elektrische/elektronische System ausfallen.

Die sich daran anschließende Fehlersuche und Reparatur verursacht nicht nur einen hohen Arbeits- und Kostenaufwand - viel entscheidender ist zumeist die Zeitdauer des Funktionsausfalls mit den dadurch bedingten Ertragsverlusten.

Es ist daher wünschenswert, die Funktionssicherheit von Kondensatoren zur Vermeidung von Störfällen zu erhöhen oder wenigstens durch eine Zustandsüberwachung von Kondensatoren hinsichtlich bestimmter Betriebsparameter, z. B. deren Temperatur oder Spannung, Problemsituationen rechtzeitig zu erkennen und dadurch Vorbeugemaßnahmen zu ermöglichen.

Problematisch daran ist jedoch, dass zusätzliche Einrichtungen zur Funktionsüberwachung von Kondensatoren auch einen zusätzlichen konstruktiven Aufwand bedeuten, für den auch ein erhöhter Platzbedarf besteht. Dieser Platz steht aber meistens nicht zur Verfügung.

Aufgabe der Erfindung ist es daher, einen Kondensator zu schaffen, der hinsichtlich eines seiner Betriebsparameter mit geringem Aufwand und Platzbedarf überwacht werden kann.

Diese Aufgabe wird erfindungsgemäß durch den Kondensator mit den Merkmalen von Anspruch 1 gelöst. Die Unteransprüche geben vorteilhafte Ausgestaltungen der Erfindung wieder.

Grundgedanke der Erfindung ist es, einen Kondensator mit einer am oder im Kondensator selbst angeordneten Messelektronik auszustatten, die zur eigenen Spannungsversorgung an die Kondensatoranschlüsse angeschlossen ist und die zu deren Betrieb notwendige Energie aus dem Kondensator selbst bezieht, wobei die Messelektronik einen die Messdaten und/oder daraus abgeleitete Daten speichernden Datenspeicher aufweist und der Datenspeicher zum Speichern einer Häufigkeit oder einer Dauer eines in einem ersten Wertebereich eines ersten Betriebsparameters erfolgenden Ereignisses in Abhängigkeit von einem zweiten Wertebereich eines zweiten Betriebsparameters eingerichtet ist.

Die Lösung ist so konzipiert, dass die erfindungsgemäß notwendige Messelektronik im Kondensator bzw. gegebenenfalls im Kondensatorblock implementiert wird, um so funktionsdominante Parameter zu erfassen und diese zeitnah zur Überwachung bereitzustellen. Insbesondere ist die Messelektronik mit ihrem wenigstens einen Sensor zum Erfassen der Betriebsparameter Spannung, Strom und/oder Temperatur eingerichtet. Diese Parameter werden speziell zeitbezogen erfasst.

Bevorzugt sollen die gespeicherten Daten drahtlos ausgelesen werden können, wobei die Datenkommunikation und visuelle Ausgabe der Daten bevorzugt über eine Software-Applikation bzw. über ein Empfangsmodul in einem entsprechenden Gerät realisiert wird. Alternativ müssten Datenanschlüsse vorgesehen werden, über die die Messelektronik kommunizieren kann.

Durch eine geeignete Datenaufbereitung kann der Anwender wichtige Funktionsinformationen erhalten, die entweder algorithmisch oder auch individuelle Zustandsbewertungen und tendenzielle Aussagen zu Änderungen des Betriebsverhaltens gestatten. Damit wird es ermöglicht, über die gesamte oder betrachtete Betriebsdauer Aussagen zu regulären Betriebsphasen und dem gegenüber auch zu Überlastungsphasen zu erhalten, woraus sich Schlussfolgerungen bezüglich der einzuhaltenden "Prozessfenster" oder für erforderliche Austauschintervalle abgeleitet werden können.

Dadurch, dass aktuelle Betriebsparameter mit Grenzvorgaben verglichen werden und auch tendenzielle Ausprägungen ermittelt werden können, können vor dem Eintritt eines Störfalls durch den Anwender geeignete Gegenmaßnahmen ergriffen werden.

Speziell ist auch vorgesehen, dass beim Abweichen von vorbestimmten Werten oder Wertebereichen, z.B. bei Überschreitung des Energieflusses, eines bestimmten Temperaturbereichs oder beim Kondensatorausfall, ein Warnsignal übermittelt und/oder ausgegeben wird.

Die Erfindung eignet sich insbesondere zur Verwendung in der Leistungselektronik, in Stromnetzen, in der Kommunikationselektronik und im Verkehrswesen, also beispielsweise bei Windenergieanlagen, Telefonnetzen, im Schienenverkehr und in diversen Produktionsanlagen.

Erfindungsgemäß ist also ein Kondensator mit zwei Kondensatoranschlüssen und einer wenigstens einen Betriebsparameter des Kondensators als Messdaten erfassenden, wenigstens einen Sensor aufweisenden Messeinrichtung vorgesehen, wobei die Messeinrichtung zur eigenen Spannungsversorgung an die Kondensatoranschlüsse des Kondensators angeschlossen ist, die Messeinrichtung einen die Messdaten und/oder daraus abgeleitete Daten speichernden Datenspeicher aufweist und der Datenspeicher zum Speichern einer Häufigkeit oder einer Dauer eines in einem ersten Wertebereich eines ersten Betriebsparameters erfolgenden Ereignisses in Abhängigkeit von einem zweiten Wertebereich eines zweiten Betriebsparameters speichert.

Da die Speicherkapazität des Speichers aufgrund der Einbausituation in den Kondensator zwangsweise gering ausfallen muss, ist ein besonderes Speichermanagement notwendig.

Zum einen ist der Speicher zum Speichern aus den erfassten Parametern abgeleiteter Werte eingerichtet. So ist der Speicher insbesondere zum Speichern der Häufigkeit oder Dauer eines in einem ersten Wertebereich eines ersten Betriebsparameters erfolgenden Ereignisses in Abhängigkeit von einem zweiten Wertebereich eines zweiten Betriebsparameters eingerichtet. Speziell ist der der erste Betriebsparameter besonders bevorzugt die Spannung des Kondensators und der zweite Betriebsparameter die Temperatur des Kondensators.

Darüber hinaus wird auch noch ein Verfahren vorgeschlagen, bei dem die Speicherbereiche bei jeder erfolgten Messung überschrieben und die gemessenen Werte kumulativ erfasst werden. Dieses wird dadurch ermöglicht, dass der mögliche Messbereich in Klassen unterteilt und die Ereignishäufigkeit eines gemessenen Werts oder die Zeitdauer des gemessenen Werts innerhalb einer Klasse gespeichert werden. Dabei findet die Messung an sich jeweils in vorbestimmten Abständen statt, wobei die bei einer erneuten Messung erfassten Werte zu den zuvor gespeicherten Werten hinzu addiert werden.

Insbesondere wird eine Datenmatrix erhalten, bei der beispielsweise die Temperatur gegen die Spannung aufgetragen wird, wobei die Temperatur und die Spannung jeweils in Klassen unterteilt ist und als Speicherwert die der jeweiligen Temperaturklasse und Spannungsklasse zugeordnete Häufigkeit eines Ereignisses oder die Zeitdauer des Ereignisses zugeordnet wird.

Entsprechend ist ein Verfahren zum Betreiben eines erfindungsgemäß ausgestalteten Kondensators mit einem Speicher vorgesehen, mit den Schritten:
a. Erfassen eines ersten Betriebsparameters des Kondensators innerhalb einer ersten vorbestimmten Zeitspanne,
b. Zuordnen der für den ersten Betriebsparameter erfassten Ereignisse und/oder Werte zu vorbestimmten Werteklassen in Abhängigkeit von der Häufigkeit der Ereignisse und/oder der Dauer der erfassten Werte in Bezug auf die vorbestimmten Werteklassen,
c. Speichern der Häufigkeit der Ereignisse und/oder der Dauer der erfassten Werte in den Werteklassen zugeordneten Speicherbereichen,
d. Erfassen des ersten Betriebsparameters des Kondensators innerhalb einer zweiten vorbestimmten Zeitspanne, und
e. Wiederholen der Schritte b. und c., wobei die Ereignisse und/oder die Dauer der erfassten Werte während der ersten vorbestimmten Zeitspanne mit den Ereignissen und/oder der Dauer der erfassten Werte während der zweiten vorbestimmten Zeitspanne miteinander addiert und in den den Werteklassen zugeordneten Speicherbereichen gespeichert werden.

Weiter bevorzugt weist die Messeinrichtung einen Sender zur kabellosen Datenübertragung der Messdaten auf. Insbesondere ist der Sender dabei zur Datenübertragung mittels Bluetooth, WLAN, ZigBee, NFC, Wibree oder WiMAX eingerichtet.

Der wenigstens eine Sensor der Messeinrichtung ist speziell ein Spannungs-, Strom- und/oder Temperatursensor.

Der Kondensator ist speziell als Becherkondensator ausgebildet und die Messeinrichtung im Deckel des Kondensators angeordnet. Insbesondere ist vorgesehen, dass die Messeinrichtung im Deckel des Kondensators vergossen ist.

Die Erfindung wird im Folgenden anhand von in den beigefügten Zeichnungen dargestellten, besonders bevorzugt ausgestalteten Ausführungsbeispiels näher erläutert. Es zeigen:
- Fig. 1: einen besonders bevorzugt ausgestalteten Kondensator nach der Erfindung in einer schematisch wiedergegebenen perspektivischen Ansicht; und
- Fig. 2: einen Screenshot einer mit dem Kondensator kommunizierenden SoftwareApplikation.

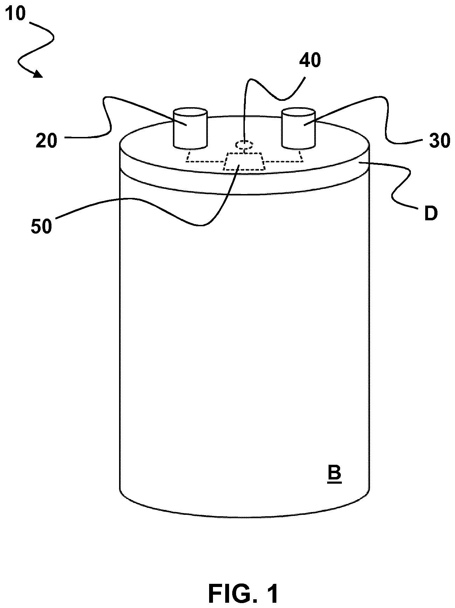

Fig. 1 zeigt einen besonders bevorzugt ausgestalteten Kondensator nach der Erfindung in einer schematisch wiedergegebenen perspektivischen Ansicht. Der Kondensator 10 ist als Becherkondensator mit einem Becher B und einem den Becher B verschließenden Deckel D ausgebildet.

Im Deckel des Kondensators 10, in dem auch die Kondensatoranschlüsse 20, 30 angeordnet sind, ist eine Messeinrichtung 50 angeordnet, die wenigstens einen Sensor 40 aufweist, der wenigstens einen Betriebsparameter des Kondensators 10 erfasst. Dabei ist die Messeinrichtung 50 zur eigenen Spannungsversorgung elektrisch an die Kondensatoranschlüsse 20, 30 des Kondensators 10 angeschlossen.

Die Spannungsversorgung des Messeinrichtung über die Kondensatoranschlüsse 20, 30 des Kondensators 10 kann bei Verwendung aktiver Sensorelemente dazu verwendet werden, die Messung als solche auszuführen. Die Spannungsversorgung wird aber auch zur Verarbeitung und Speicherung, sowie zur kabellosen Übertragung der Daten benötigt.

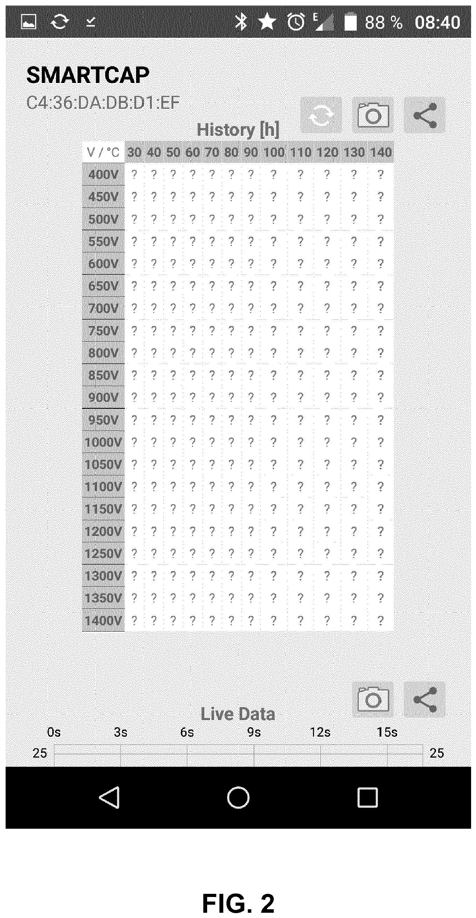

Die vom Kondensator 10 erfassten Daten werden bevorzugt drahtlos an einen Empfänger, beispielsweise ein Smartphone o. ä, übermittelt und mittels einer geeigneten Software-Applikation visualisiert. In dem in Fig. 2 gezeigten Beispiel werden mithilfe der Messeinrichtung, die am Kondensator 10 auftretende Spannung, dessen Temperatur sowie die Zeitdauer der erfassten Ereignisse in h in einer nach Klassen aufbereiteten Matrix dargestellt. Aufgrund dieser Informationen kann ohne weiteres eine Aussage über den allgemeinen Betriebszustand des Kondensators auch prädiktiv getroffen werden.

## Patentansprüche

1. Kondensator (10) mit
- zwei Kondensatoranschlüssen (20, 30), und
- einer wenigstens einen Betriebsparameter des Kondensators (10) als Messdaten erfassenden, wenigstens einen Sensor (40) aufweisenden Messeinrichtung (50), die zur eigenen Spannungsversorgung an die Kondensatoranschlüsse (20, 30) des Kondensators (10) angeschlossen ist,
**dadurch gekennzeichnet, dass**
die Messeinrichtung (50) einen die Messdaten und/oder daraus abgeleitete Daten speichernden Datenspeicher aufweist, und
der Datenspeicher zum Speichern einer Häufigkeit oder einer Dauer eines in einem ersten Wertebereich eines ersten Betriebsparameters erfolgenden Ereignisses in Abhängigkeit von einem zweiten Wertebereich eines zweiten Betriebsparameters eingerichtet ist.

2. Kondensator (10) nach Anspruch 1, **dadurch gekennzeichnet, dass** die Messeinrichtung (50) einen Sender zur kabellosen Datenübertragung der Messdaten aufweist.

3. Kondensator (10) nach Anspruch 2, **dadurch gekennzeichnet, dass** der Sender zur Datenübertragung mittels Bluetooth, WLAN, ZigBee, NFC, Wibree oder WiMAX eingerichtet ist.

4. Kondensator (10) nach einem der vorhergehenden Ansprüche, **dadurch gekennzeichnet, dass** der wenigstens eine Sensor (40) ein Spannungs-, Strom- und/oder Temperatursensor ist.

5. Kondensator (10) nach Anspruch 1, **dadurch gekennzeichnet, dass** der erste Betriebsparameter die Spannung des Kondensators (10) und der zweite Betriebsparameter die Temperatur des Kondensators (10) ist.

6. Kondensator (10) nach einem der vorhergehenden Ansprüche, **dadurch gekennzeichnet, dass** der Kondensator (10) als Becherkondensator ausgebildet und die Messeinrichtung (50) im Deckel des Kondensators (10) angeordnet ist.

7. Verfahren zum Betreiben eines Kondensators (10) mit den Merkmalen von Anspruch 1, **gekennzeichnet durch** die Schritte:
a. Erfassen eines ersten Betriebsparameters des Kondensators (10) innerhalb einer ersten vorbestimmten Zeitspanne,
b. Zuordnen der für den ersten Betriebsparameter erfassten Ereignisse und/oder Werte zu vorbestimmten Werteklassen in Abhängigkeit von der Häufigkeit der Ereignisse und/oder der Dauer der erfassten Werte in Bezug auf die vorbestimmten Werteklassen,
c. Speichern der Häufigkeit der Ereignisse und/oder der Dauer der erfassten Werte in den Werteklassen zugeordneten Speicherbereichen,
d. Erfassen des ersten Betriebsparameters des Kondensators (10) innerhalb einer zweiten vorbestimmten Zeitspanne, und
e. Wiederholen der Schritte b. und c., wobei die Ereignisse und/oder die Dauer der erfassten Werte während der ersten vorbestimmten Zeitspanne mit den Ereignissen und/oder der Dauer der erfassten Werte während der zweiten vorbestimmten Zeitspanne miteinander addiert und in den den Werteklassen zugeordneten Speicherbereichen gespeichert werden.
